# EUROPEAN PATENT SPECIFICATION

(11) **EP 0 501 434 B1**
(45) Date of publication and mention of the grant of the patent: **22.01.1997**
(21) Application number: 92103222.3
(22) Date of filing: 26.02.1992
(51) Int. Cl.: H03H 2/00, H01F 10/24, H01F 10/28

(54) **Use of a garnet thin film in a magnetostatic-wave device**
Verwendung eines Garnet Dünnfilms in einem magnetostatischen Wellen Gerät
Emploi d'un couche mince de garnet dans un dispositif à ondes magnétostatiques

(30) Priority: 28.02.1991 JP 59705/91; 28.02.1991 JP 59706/91; 28.02.1991 JP 59707/91
(43) Date of publication of application: 02.09.1992
(73) Proprietor: MURATA MANUFACTURING CO., LTD., Nagaokakyo-shi Kyoto-fu 226 (JP)
(72) Inventor: Kumatoriya, Makoto, Nagaokakyo-shi, Kyoto-fu (JP); Fujino, Masaru, Takatsuki-shi, Osaka-fu (JP); Mizuno, Shinobu, Nagaokakyo-shi, Kyoto-fu (JP); Aota, Mitsuhiro, Nagaokakyo-shi, Kyoto-fu (JP); Takagi, Hiroshi, Ohtsu-shi, Shiga-ken (JP)
(74) Representative: von Kreisler, Alek, Dipl.-Chem.

(56) References cited:
- US-A- 4 968 954

## Description

The present invention relates to a garnet thin film used in magnetostatic-wave devices and, more particularly, a ferrimagnetic material for magnetostatic wave devices comprising a garnet thin film of the ferrimagnetic material epitaxially grown on a substrate of gadolinium-gallium-garnet.

Recently, study of magnetostatic wave devices has developed rapidly and its achievements have been reported in various papers. For example, some examples of magnetostatic wave devices are described by J.D. Adam, M.R. Daniel and D.K. Schroder in "Magnetostatic-wave devices move microwave design into gigaherts realm", Electronics, May, 1980, pp. 123-128. Also, a new configuration for a magnetostatic wave filter is discussed by T. Nishikawa, K. Wakino, H. Taraha, T.Okada, S. Shinmura and Y. Ishikawa in "a low loss magnetostatic wave filter using parallel strip transducers", Microwave and RF Engineering, September/October 1989, pp.63-68.

Such magnetostatic wave devices generally comprise a thin film of a ferrimagnetic material, generally, yttrium-iron-garnet (YIG) of the chemical formula Y₃Fe₂(FeO₄)₃, grown by liquid-phase epitaxy techniques on a substrate of gadolinium-gallium-garnet (GGG) of the chemical formula Gd₃Ga₂(GaO₄)₃. The epitaxially grown YIG film makes it possible to reduce the difference between input and output signals of the magnetostatic wave devices because of its very small magnetic resonance half linewidth (ΔH).

However, the YIG films have such a disadvantage that the change in saturation magnetization (4πMₛ) with temperature is large and of the order of about 2100 ppm/°C. Thus, in order to improve temperature characteristics of magnetostatic-wave devices, it is required to choose a permanent magnet with a suitable temperature coefficient. However, it is difficult to minimize the temperature coefficient of the magnetostatic wave device because of limited kinds of permanent magnet materials and because of the fixed temperature coefficient of saturation magnetization of the YIG films.

US-A-4,968,954 (Ryuo et al.) discloses materials for magnetostatic wave devices that comprise an epitaxial layer formed on a substrate of rare earth gallium garnet, having a chemical composition of the formula:

Y₃₋ₓBiₓFe_{5-y}Ga_{y}O₁₂

in which the subscript x takes a value in the range from 0.01 to 0.9, and the subscript y takes a value in the range from 0.49 to _{1.0.}

It is therefore an object of the present invention to provide a material for magnetostatic-wave devices, which makes it possible to provide a ferrimagnetic thin film with any desired temperature coefficient of saturation magnetization (4πMₛ), without causing increase in magnetic resonance half linewidth (ΔH).

According to the present invention there is provided a material for magnetostatic wave devices comprising a thin film of the material epitaxially grown on a substrate of gadolinium-gallium-garnet (GGG), said material having a composition expressed by the general formula (I):

Y₃₋ₓBiₓFe_{5-y}Ga_{y}O₁₂ (I)

where x and y are mole fractions of Bi and Ga, 0 ≤ x ≤ 0.41, and 0 ≤ y less than 0,49, said composition having a set of x and y falling in the area encompassed by a polygon ABCDE defined by points A (0, 0), B (0.23, 0), C (0.41, 1), D (0.15, 1) and E (0, 0.1) in a phase diagram of a binary system with x as abscissa and y as ordinate, except for a set of x and y falling on the point A.

The present invention makes it possible to produce a ferrimagnetic thin films with any desired temperature coefficient of saturation magnetization ranging from about 500 to about 2000 ppm/°C, without causing increase in the magnetic resonance half linewidth (ΔH). Accordingly, it is possible to improve the temperature characteristics of magnetostatic wave devices by the suitable choice of the permanent magnet material.

Further, the present invention makes it possible to produce excellent magnetic garnet films as the difference of the lattice constant between the garnet film and the GGG substrate can be minimized to not more than 0.01 Å.

The above and other objects, features and advantages of the present invention will be understood clearly from the following explanations with reference to several examples.

### Example 1

Powdered materials of Fe₂O₃, Y₂O₃, Bi₂O₃ and Ga₂O₃ were weighed and mixed so that the product has a composition of the general formula (II):

Y₃₋ₓBiₓFe_{5-y}Ga_{y}O₁₂

where x and y are mole fractions of Bi and Ga and take values as shown in Table 1. Using the resultant mixtures, there were prepared magnetic garnet films on substrates of Gd₃Ga₅O₁₂ by the liquid-phase epitaxy (LPE) in the same manner as Example 1.

For each garnet film produced, measurements were made on the lattice constant, saturation magnetization (4πMₛ), temperature coefficient (TC) of 4πMₛ, and magnetic resonance half linewidth (ΔH). Results are shown in Table 2. In the table, the specimens with an asterisk (*) are those out of the scope of the present invention.

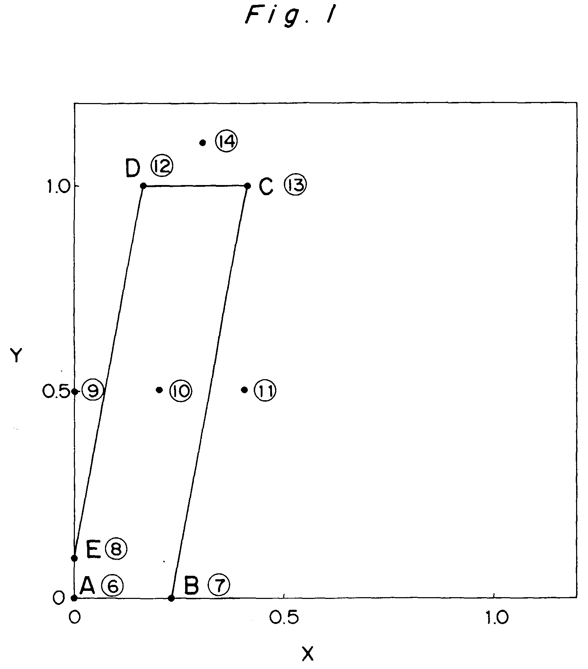

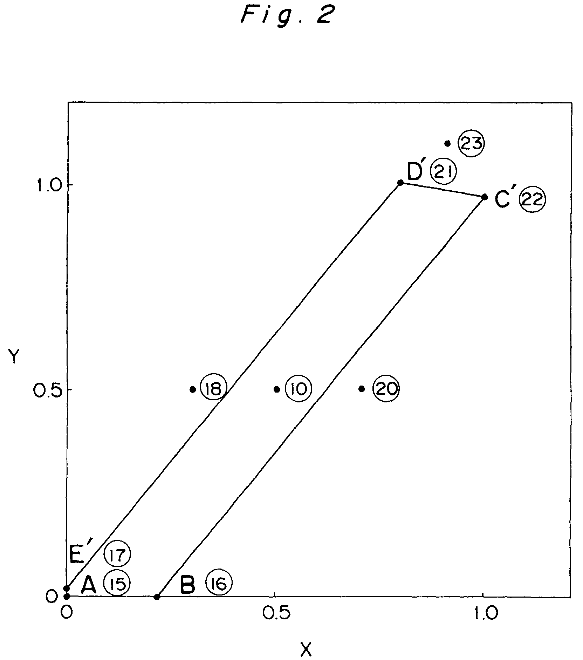

The compositions of the resultant garnet films are plotted in a binary phase diagram of Fig. 1 with x in the general formula (I) as abscissa and y in that formula as ordinate, along with the area of the composition falling in the scope of the present invention. The numbers in Fig. 1 correspond to the respective specimen numbers.

**Table 1**

| No. | x | y | 4πMₛ (G) | ΔH (Oe) | TC of 4πMₛ (ppm/°C) | lattice constant (A) |
|---|---|---|---|---|---|---|
| 1* | 0 | 0 | 1800 | 0.6 | -2100 | 12.376 |
| 2 | 0.23 | 0 | 1740 | 1.3 | -1300 | 12.393 |
| 3 | 0 | 0.1 | 1500 | 0.9 | -2200 | 12.373 |
| 4* | 0 | 0.5 | Good films were never obtained | | | |
| 5 | 0.2 | 0.5 | 950 | 1.4 | -1700 | 12.381 |
| 6* | 0.4 | 0.5 | Good films were never obtained | | | |
| 7 | 0.16 | 1 | 680 | 2.0 | -2000 | 12.373 |
| 8 | 0.41 | 1 | 630 | 2.5 | -1500 | 12.393 |
| 9* | 0.3 | 1.1 | 570 | 5.5 | -1400 | 12.385 |

As can be seen from the data for specimen No. 4 or 6, if the composition has a set of x and y falling in the area out of the line BC or the line DE, the difference in the lattice constant between the GGG substrate and the magnetic garnet film becomes more than 0.01A, causing cracking of the film, thus making it impossible to obtain garnet films with good quality.

Further, as can be seen from the data for specimen No. 9, if the composition has a set of x and y falling in the area out of the line CD, the magnetic resonance half linewidth (ΔH) becomes more than 5 Oe, thus making it impossible to use it as a material for film in the magnetostatic wave devices.

As can be seen from the data for specimen No. 1, this composition, i.e., YIG, possesses a large temperature coefficient of the saturation magnetization (4πMₛ). The composition with x = 0 and y = 0 is of course excluded from the scope of the present invention.

For the reasons mentioned above, the composition of the general formula (I) has been limited to those having a set of values of x and y falling in the area encompassed by the polygon ABCDE defined by the points A (0, 0), B (0.23), C (0.41, 1), D (0.15, 1) and E (0, 0.1) in Fig. 1, except for a set of x and y falling on the point A.

## Claims

1. A material of garnet thin films used in magnetostatic wave devices comprising a garnet thin film of a ferrimagnetic material epitaxially grown on a substrate of Gd₃Ga₂(Ga_{O4})₃, said material having a composition expressed by the general formula (I):
Y₃₋ₓBiₓFe_{5-y}Ga_{y}O₁₂ (I)
where x and y are mole fractions of Bi and Ga, 0 ≤ x ≤ 0.41, and 0 ≤ y less than 0,49, said composition having a set of x and y falling in the area encompassed by a polygon ABCDE defined by points A (0, 0), B (0.23, 0), C (0.41, 1), D (0.15, 1) and E (0, 0.1) in a phase diagram of a binary system with x as abscissa and y as ordinate, except for a set of x and y falling on the point A.

## Patentansprüche

1. Material für Garnett-Dünnfilme, die in Vorrichtungen für magnetostatische Wellen verwendet werden, umfassend einen Garnett-Dünnfilm eines ferrimagnetischen Materials, das auf einem Substrat von Gd₃Ga₂(Ga₀₄)₃ epitaxial gezüchtet wurde, wobei das Material eine Zusammensetzung hat, die durch die allgemeine Formel (I):
Y₃₋ₓBiₓFe_{5-y}Ga_{y}O₁₂ (I)
ausgedrückt wird, worin x und y Molfraktionen von Bi und Ga sind, 0 ≤ x ≤ 0,41 und 0 ≤ y kleiner als 0,49 sind, die Zusammensetzung eine Menge von x und y - die in die Fläche fällt, die durch ein Polygon ABCDE umschlossen wird, das durch die Punkte A(0, 0), B(0,23, 0), C(0,41, 1), D(0,15, 1) und E(0, 0,1) definiert ist - in einem Phasendiagramm eines binären Systems mit x als Abszisse und y als Ordinate, außer für eine Menge von x und y, die auf den Punkt A fällt.

## Revendications

1. Matériau formé de fines couches de grenat, utilisé dans des dispositifs à ondes magnétostatiques, comportant une fine couche de grenat d'un matériau ferrimagnétique obtenu par croissance épitaxiale sur un substrat de Gd₃Ga₂(GaO₄)_{3'}, ledit matériau ayant une composition exprimée par la formule générale (I):
Y₃₋ₓBiₓFe_{5-y}Ga_{y}O₁₂ (I)
où x et y sont des fractions molaires de Bi et Ga, 0 ≤ x ≤ 0,41, et 0 ≤ y < 0,49, ladite composition ayant un couple de x et y qui tombe dans la zone entourée par un polygone ABCDE défini par les points A (0, 0), B (0,23, 0), C (0,41, 1), D (0,15, 1) et E (0, 0,1) dans un diagramme de phase d'un système binaire avec x comme abscisse et y comme ordonnée, à l'exception du couple de x et y tombant au point A
